Europäisches Patentamt

European Patent Office

Office européen des brevets

(19)

(11) Publication number: **0 087 881**
**B1**

# EUROPEAN PATENT SPECIFICATION

(45) Date of publication of patent specification: **21.11.85**

(51) Int. Cl.⁴: **C 04 B 37/02, H 01 H 33/66**

(21) Application number: **83300744.6**

(22) Date of filing: **15.02.83**

(54) **Process for bonding, copper or copper-chromium alloy to ceramics, and bonded articles of ceramics and copper or copper-chromium alloy.**

(30) Priority: **18.02.82 JP 24758/82**
**04.03.82 JP 34247/82**

(43) Date of publication of application:
**07.09.83 Bulletin 83/36**

(45) Publication of the grant of the patent:
**21.11.85 Bulletin 85/47**

(84) Designated Contracting States:
**CH DE FR GB IT LI NL SE**

(56) References cited:
**GB-A-1 051 393**
**GB-A-2 059 323**
**US-A-3 296 017**

(73) Proprietor: **Kabushiki Kaisha Meidensha**
**1-17, Ohsaki 2-chome**
**Shinagawa-ku Tokyo 141 (JP)**

(72) Inventor: **Kashiwagi, Yoshiyuki**
**5-10, Ohsaki 2-chome**
**Shinagawa-ku Tokyo 141 (JP)**
Inventor: **Suzuki, Tsutai**
**8-20, Ohsaki 2-Chome**
**Shinagawa-ku Tokyo 141 (JP)**

(74) Representative: **Evans, David Charles et al**
**F.J. CLEVELAND & COMPANY 40-43, Chancery Lane**
**London, WC2A 1JQ (GB)**

EP 0 087 881 B1

Courier Press, Leamington Spa, England.

# Description

The present invention relates to a process for bonding a copper or a copper-chromium alloy article to ceramics, and to bonded articles of ceramics and a copper or a copper-chromium alloy article.

Heretofore, an effective bonding of a copper article to ceramics, e.g. alumina ceramics, especially really effective bonding such as employed in a pressure or vacuum envelope, has been performed in accordance with the following process including the so-called Telefunken method.

First, a metallizing paste is applied to the surfaces to be bonded of an alumina ceramics material. A major component of said paste is a refractory metal powder as such, Mo or W, which is similar to alumina in its coefficient of thermal expansion and sintering properties. Second, the applied layer of the metallizing paste is sintered under a deoxidizing atmosphere of a wet hydrogen gas at a temperature near the softening point of alumina of 1300°C to 1500°C, to form a compact metallized layer effectively bonded to the substrate of the alumina ceramics. Third, nickel or gold plating is applied to the metallized layer in order to ensure effective contact between the layer and a molten brazing-material. Finally, the copper article and the ceramics material are heated together at a temperature at which the solid brazing-material trapped between the surfaces to be bonded thereof forms a bonding layer and then the product is slowly cooled, thus bonding the materials firmly to each other.

This process for bonding a copper article to alumina ceramics entails some disadvantages as follows:

(1) an expensive metal as such, e.g. Mo or W must be employed;

(2) the number of steps required is high since an independent metallizing process in which a metal such as Mo or W is employed must be included in the bonding process;

(3) in the metallizing process, a completely sintered alumina ceramics is heated again at a temperature of about the softening point of alumina; and

(4) brazing-material must be employed.

In conclusion, the known process for bonding a copper article to alumina ceramics material entails such disadvantages as high cost, technical difficulties in control and a long process time.

Other methods of bonding a metallic member to a non-metallic ceramics substrate are known from GB—A—2 059 323. In this process a metal oxide layer is interposed between the surfaces to be conjoined.

## Summary of the invention

A primary object of the present invention is to provide a process for bonding a copper article to ceramics which produces a firmly bonded assembly, at low cost, with reduced number of process step and a reduced process time.

According to a first feature of the invention there is provided a process for bonding a copper article to ceramics which comprises:

interposing chromium oxide between surfaces of the ceramics and the copper article which are to be bonded;

heating a temporary assembly of the ceramics, the copper article and the chromium oxide under an atmosphere which does not oxidize copper, at a temperature of less than the melting point of copper; and then slowly cooling the so-bonded assembly.

According to a second feature of the invention there is provided an article of ceramics and copper which comprises:

ceramics;

a copper article; and

chromium oxide bonding said ceramics and said copper to each other.

According to a third feature of the invention there is provided a process for bonding a copper article to ceramics which comprises:

interposing a copper-chromium alloy consisting of copper and 0.1 to 0.6 wt. % chromium between surfaces to be bonded of the ceramics and the copper article;

heating a temporary assembly of the ceramics, copper article and copper-chromium alloy under an atmosphere adapted to oxidize chromium but not to oxidize copper, at a temperature of less than the melting point of copper; and then slowly cooling the so-bonded assembly.

According to a fourth feature of the invention there is provided a process for bonding a copper-chromium alloy article to a ceramics material which comprises:

heating a temporary assembly of the ceramics and a copper-chromium alloy article comprising 0.1 to 0.6 wt. % chromium, with the surfaces to be bonded thereof in contact, under an atmosphere adapted to oxidize chromium but not to oxidize copper, at a temperature of less than the melting point of the copper chromium alloy; and then slowly cooling the so-bonded assembly.

According to a fifth feature of the invention there is provided an article of ceramics and a copper-chromium alloy material which comprises:

said ceramics; and

a copper-chromium alloy article comprising 0.1 to 0.6 wt. % chromium, both directly bonded to each other by heating a temporary assembly thereof at a temperature below the melting point of the copper chromium alloy.

The other objects and advantages of the present invention will be apparent from the following description, which are included by way of example only.

## Brief description of the drawing

Fig. 1 is a photomicrograph by an X-ray microanalyzer of secondary electron in a surface of a cut section in a bonded portion of an article of bonded alumina ceramics and copper according to the first or second embodiment of the bonding process of the present invention. In this photomicrograph the dark part in the right side indicates alumina ceramics, the whitish part on the left side copper, and the wavy part at the center chromium oxide.

Fig. 2 is a photomicrograph by the X-ray microanalyzer of the characteristic X-ray of chromium in the surface of the cut section in the bonded portion of the article of the bonded alumina ceramics and copper, in which photomicrograph a white part at the center indicates chromium.

Fig. 3 is a photomicrograph by the X-ray microanalyzer of the characteristic X-ray of oxygen in the surface of the cut section in the bonded portion of the article of the bonded alumina ceramics and copper, in which photomicrograph a group of dispersed white points in the right side indicates oxygen.

Fig. 4 is a photomicrograph by the X-ray microanalyzer of the characteristic X-ray of aluminium in the surface of the cut section in the bonded portion of the article of the bonded alumina ceramics and copper article, in which photomicrograph the white part in the right side indicates aluminium.

Fig. 5 is a photomicrograph by the X-ray microanalyzer of the characteristic X-ray of copper in the surface of the cut section in the bonded portion of the article of the bonded alumina ceramics and copper, in which photomicrograph the white part in the left side indicates copper.

Fig. 6 is a longitudinal half-section of a vacuum interrupter a vacuum envelope of which includes a bonding between an insulating ceramic cylinder and copper according to the first to third embodiments of a bonding process of the present invention.

Fig. 7 is a longitudinal half-section of a vacuum interrupter a vacuum envelope of which includes a bonding between an insulating ceramic cylinder and a copper-chromium alloy according to the fourth embodiment of the bonding process of the present invention.

Description of the preferred embodiments

Referred to the attached drawing, the preferred embodiments of the process for bonding of copper or of a copper-chromium alloy to ceramics, and the preferred embodiments of articles of by the process bonded ceramics and copper or a copper-chromium alloy will be described in detail.

In accordance with the first embodiment of the bonding process of the present invention, bonding copper to ceramics is performed by the following process.

First, a chromium film of about 1 μm thickness is formed by a continuous vacuum deposition on a surface to be bonded of alumina ceramics. Second, the chromium film is continuously heated under an air atmosphere of between 133.3 and 13.33 mPa ($10^{-3}$ and $10^{-4}$ Torr) at about 500°C for 10 minutes so as to be converted into a chromium oxide film in which chromium (III) oxide dominates. Third, a temporary assembly of the alumina ceramics with the copper article in contact with the chromium oxide film is continuously heated under an inert atmosphere of between 13.33 and 1.333 mPa ($10^{-4}$ and $10^{-5}$ Torr) at 1000°C for 25 minutes in such a manner that the surface of the copper is not oxidized. Following the heating step, the bonded assembly is slowly cooled within a vacuum furnace so as to be firmly and hermetically bonded; while plastic deformation of the copper neutralizes the thermal stress generated in the alumina ceramics, copper and boundary therebetween.

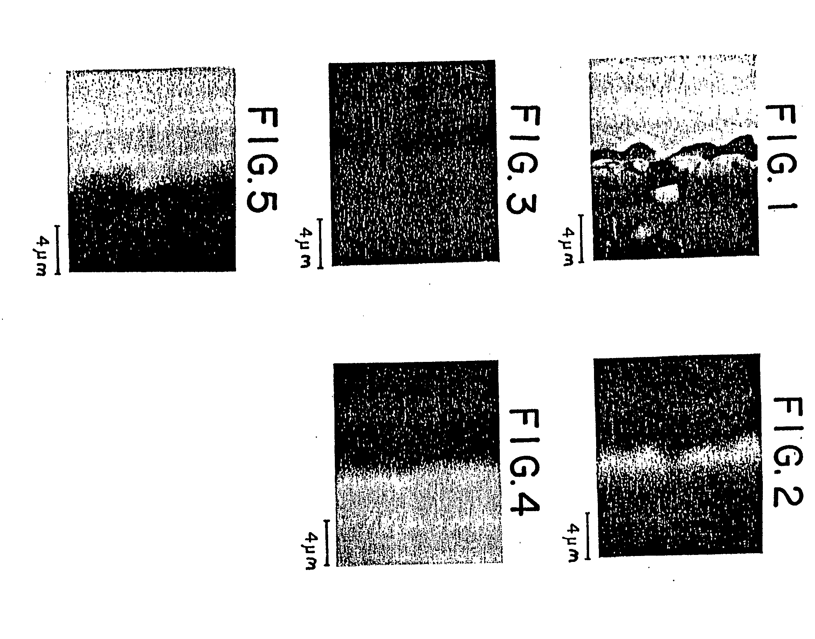

The bonded portion of the article produced by the above process was analyzed by the X-ray microanalyzer, resulting in the photomicrographs of Figs. 1 to 5. All of the figures are represented at the same enlarged scale. Therefore, it will be found by overlapping the figures one on another, that chromium has permeated both the alumina ceramics and copper in the bonding boundary between the right alumina ceramics and the left copper.

According to the first embodiment of the bonding process, experiments established that the bond strength between alumina ceramics and copper was no less than 49.03 N/mm$^2$ (5 kg/mm$^2$).

Moreover, the first embodiment of the bonding process according to the present invention may be performed as follows:

First, a chromium film of not less than 10 nm thickness is formed by vacuum deposition on a surface to be bonded of any ceramics such as alumina ceramics, mullite ceramics, zircon ceramics or steatite ceramics. Second, the chromium film is continuously heated under an air atmosphere of not less than 1.333 mPa ($10^{-5}$ Torr) at not less than 100°C for not less than 10 minutes to be converted into a chromium oxide in which chromium (III) oxide dominates. Third, a temporary assembly of the ceramics and copper, each contact having a surface within the chromium oxide film, is continuously heated under an inert atmosphere of not more than 13.33 mPa ($10^{-4}$ Torr) e.g. within a vacuum furnace, or under helium gas or hydrogen gas, at a temperature of between 900°C and melting point of copper, for not less than 10 minutes in such a manner that the surface of the copper is not oxidized. Following the heating step, the bonded assembly is slowly cooled under vacuum, helium gas or hydrogen gas, thus producing an article in which the ceramics and copper are stoutly and hermetically bonded to each other.

In the first embodiment of the bonding process, experiments established that where a chromium film was formed by plating, the film thickness might be not less than 0.1 μm in order to produce the bond strength similar to that achieved when the chromium film is applied by vacuum deposition. Moreover, in the first embodiment of the bonding process, experiments established that where a chromium film was formed by applying a chromium paste, which was a preparation in the paste state of a chromium powder of less than 100 mesh (0.15 mm), and a suitable binder; the film thickness may also be not less than 0.1 µm in order to produce a bond strength similar to that achieved when the chromium film is applied by vacuum deposition.

Moreover, in the first embodiment of the bonding process, experiments established that the oxidizing treatment of the chromium film required the following conditions:—

an air pressure of not less than 1.333 mPa ($10^{-5}$ Torr);

a temperature of not less than 100°C;

a heating time of not less than 10 minutes;

a chromium film when applied by vacuum deposition of a 10 nm thickness or when applied by plating or by applying as a chromium paste, of a 0.1 µm thickness.

The reason why the conditions are moderate is believed to lie in that strong chemical affinity between chromium and oxygen acts to convert chromium into chromium oxide even in the presence of only small amounts of oxygen gas.

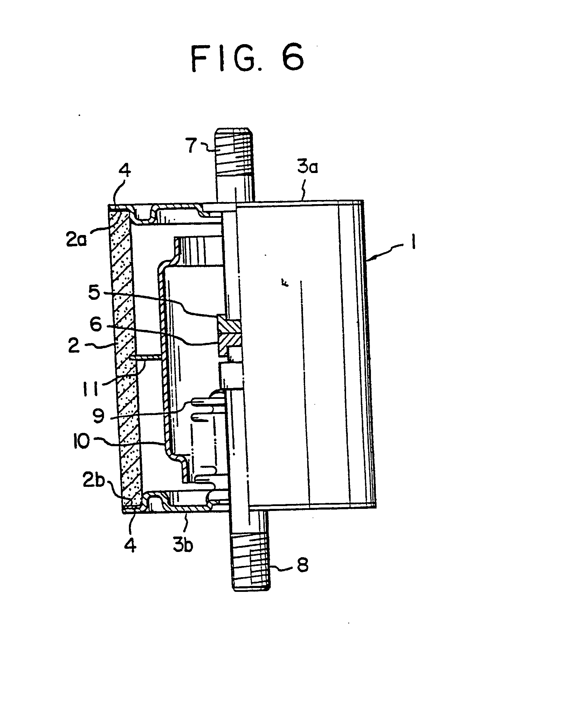

In Fig. 6, a vacuum interrupter including a vacuum envelope 1 which is constructed in a vacuum-tight manner by applying the first embodiment of the bonding process is illustrated.

The vacuum envelope 1 comprises in the main an insulating cylinder 2 of insulating ceramics as such, alumina ceramics, mullite ceramics, zircon ceramics or steatite ceramics, and copper end plates 3a and 3b in the disc-shape each of which is to be hermetically bonded to each end surface 2a or 2b of the insulating cylinder 2 via a chromium oxide film 4 on each end surface 2a or 2b.

Now, the other fabrication of the vacuum interrupter will be described hereinafter, except the above bonded portion between the insulating cylinder 2 and the copper end plates 3a and 3b. Located in the vacuum envelope 1 is a pair of separable stationary and movable contacts 5 and 6. A stationary lead rod 7 connected to the stationary contact 5 is provided extending outwardly of the vacuum envelope 1 via the aperture at the center of the copper end plate 3a. A movable lead rod 8 connected to the movable contact 6 is provided extending outwardly of the vacuum envelope 1 via the aperture at the center of the copper end plate 3b. The stationary lead rod 7 and the copper end plate 3a are by brazing sealed therebetween in a vacuum-tight manner. The movable lead rod 8 and the copper end plate 3b are sealed therebetween in a vacuum-tight manner by means of metal bellows 9, e.g., of austenitic stainless steel brazed to both the members.

Located between the pair of the stationary and movable contacts 5 and 6 and the insulating cylinder 2 is a generally cylindrical metal shield 10 which is supported at the center of the outer periphery of the metal shield 10 by an inwardly extending metal flange 11 which is secured to the inner periphery of the insulating cylinder 2.

The inside of the vacuum envelope 1 is highly evacuated into no more than 13.33 mPa ($10^{-4}$ Torr).

The vacuum interrupter is fabricated through the following process. First, a chromium film is applied by vacuum deposition to a thickness of not less than 10 nm or a chromium film is applied by plating or as a paste to a thickness of not less than 0.1 µm on each end surface 2a or 2b of the insulating cylinder 2. Second, the chromium film is continuously heated under an air atmosphere of no less than 1.333 mPa ($10^{-5}$ Torr) at a temperature of no less than 100°C but less than a softening point of alumina to be converted into the chromium oxide film 4. Third, the metal shield 10 is provided to the inner periphery of the insulating cylinder via the inwardly extending metal flange 11. Fourth, the copper end plate 3a which is provided with the stationary contact 5 and the stationary lead rod 7 is provided on the end surface 2a of the insulating cylinder 2 while the copper end plate 3b which is provided with the movable contact 6, the movable lead rod 8 and the metal bellows 9 are provided on the end surface 2b of the insulating cylinder 2. Thus, the temporary assembly step of the vacuum interrupter is completed. Fifth, the temporarily assembled vacuum interrupter is located under a vacuum of no more than 13.33 mPa ($10^{-4}$ Torr) in, for example, a vacuum furnace.

Sixth, the temporarily assembled vacuum interrupter, while the inside of the vacuum envelope 1 is evacuated to a vacuum of not more than 13.33 mPa ($10^{-4}$ Torr) is continuously heated at a temperature of no less than 900°C but less than melting point of copper for not less than 10 minutes and then slowly cooled under a vacuum of not more than 13.33 mPa ($10^{-4}$ Torr). Thus, a vacuum seal of the vacuum envelope 1 is completed. The vacuum envelope 1 is hermetic, shock resistant and inexpensive.

In the fabricating process of the vacuum interrupter, the temporarily assembled vacuum interrupter may be continuously heated under a helium or hydrogen gas atmosphere so as not to oxidize copper, at a temperature of no less than 900°C but less than melting point of copper, for not less than 10 minutes, and then slowly cooled under the same gas atmosphere. In this embodiment, any one of the stationary and movable lead rods 7 and 8, and the copper end plates 3a and 3b is provided with evacuating tubes or holes through which the vacuum envelope 1 is finally evacuated.

The second embodiment of the bonding process of the present invention is different from the above first embodiment of the bonding process because previously oxidized chromium is employed as a bonding agent for the second embodiment.

The chromium oxide film is formed on the ceramics surface to be bonded by vacuum ion deposition or by applying chromium oxide paste, under the same conditions as those of the first embodiment.

The third embodiment of the bonding process of the present invention is now described.

First, a foil of between about 0.1 and 2 mm thickness which is made of a copper-chromium alloy including chromium at 0.1 to 0.6 wt. % is interposed between surfaces to be bonded of ceramics and a copper article.

Second, a temporary assembly of the ceramics, copper article and a foil of the copper-chromium alloy is continuously heated under a vacuum of not more than 13.33 mPa ($10^{-4}$ Torr) or under a gas atmosphere, which oxidizes chromium but does not oxidize copper, at a temperature of not less than 900°C but less than melting point of copper for not less than 10 minutes, and is then slowly cooled under the same vacuum or gas atmosphere. Thus, the third embodiment produced an article of ceramics and copper materials both of which were stoutly and hermetically bonded to each other, similar to the first embodiment of the bonding process.

In the third embodiment of the bonding process, experiments established that where the amount of added chromium fell outside the range of between 0.1 to 0.6 wt. %, the bond strength obtained was insufficient for a vacuum seal.

A vacuum envelope of a vacuum interrupter which is to be fabricated by applying the third embodiment of the bonding process, is obtainable by employing a foil of a copper-chromium alloy as defined in a vacuum envelope 1 as shown in Fig. 6 instead of the chromium oxide film 4. Accordingly, a process for fabricating a vacuum envelope of a vacuum interrupter in accordance with the third embodiment of the bonding process is more advantageous than the fabricating processes of a vacuum envelope of a vacuum interrupter in accordance with both the first and second embodiments of the bonding process, because the number of steps is reduced along with manufacturing time.

The bonding of a copper-chromium alloy as defined to ceramics according to the fourth embodiment of the bonding process of the present invention is now described.

A temporary assembly of the ceramics, and copper-chromium alloy, both which are by each other overlapped on the surfaces to be bonded, is continuously heated under a vacuum of not more than 13.33 mPa ($10^{-4}$ Torr) or under a gas atmosphere to oxidize chromium but not to oxidize copper, at a temperature of not less than 900°C but less than melting point of the copper-chromium alloy, for not less than 10 minutes; and then slowly cooled under the same vacuum or gas atmosphere. Thus, the fourth embodiment of the bonding process produced an article of the bonded ceramics, and the copper-chromium alloy both which are stoutly and hermetically bonded to each other as such as the first or second embodiment of the bonding process.

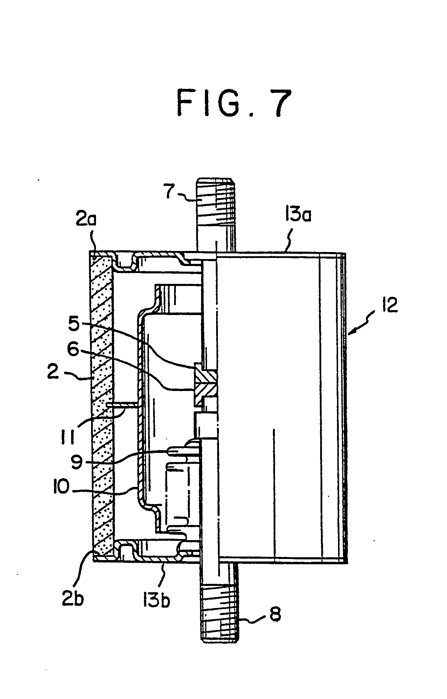

Shown in Fig. 7 is a vacuum interrupter including a vacuum envelope 12 fabricated by applying the fourth embodiment of the bonding process.

The vacuum interrupter of Fig. 7 is different from the vacuum interrupter of Fig. 6 in two points that the end plates 13a and 13b in Fig. 7 are made of the copper-chromium alloy and that there is no chromium oxide film to bond on the end surfaces 2a and 2b of the insulating cylinder 2. Accordingly, a process for fabricating a vacuum envelope of a vacuum interrupter in accordance with the fourth embodiment of the bonding process is more advantageous than the fabricating process of a vacuum envelope of a vacuum interrupter in accordance with the third embodiment of the bonding process, because a step is omitted and process performing time is thus reduced.

A bonding process of the present invention is applicable to a vacuum envelope of a vacuum interrupter of a structure as follows:—

(1) One which comprises a cylinder of copper or a copper-chromium alloy (0.1 to 0.6 wt. %), and end plates of insulating ceramics for closing in a vacuum-tight manner both the end openings of the cylinder.

(2) One which comprises a bottom cylinder cup of copper or a copper chromium alloy, and an end plate of insulating ceramics for closing in a vacuum-tight manner the end opening of the bottom cylinder.

(3) One which comprises not less than two insulating cylinders of insulating ceramics that are connected in series by means of metal sealing fittings in the short circular ring-shaped cylinder form of copper or the copper-chromium alloy.

(4) One which comprises a single insulating cylinder which is a hermetically constructed, series connected, insulating cylinder of insulating ceramics and copper or a copper-chromium alloy. The end plates or caps in the bottom cylinder being formed of copper or a copper-chromium alloy for closing in a vacuum-tight manner both the end openings of the single insulating cylinder.

The bonding process of the present invention thus provides various hermetic envelopes which are good in hermeticity and shock resisting properties.

## Claims

1. A process for bonding a copper article to ceramics which comprises:

interposing chromium oxide between surfaces of the ceramics and the copper article which are to be bonded;

Heating a temporary assembly of the ceramics, the copper article, and the chromium oxide under an atmosphere which does not oxidize copper, at a temperature of less than the melting point of copper; and then slowly cooling the so-bonded assembly.

2. A process as defined in Claim 1, wherein said chromium oxide interposing step includes the steps of coating a chromium film of not less than 10 nm thickness onto the ceramics surface to be bonded and of oxidizing the chromium film.

3. A process as defined in Claim 2, wherein said chromium film oxidizing step is performed by continuously heating the chromium film under an air atmosphere of no less than 1.333 mPa ($10^{-5}$ Torr) at a temperature of no less than 100°C for no less than 10 minutes.

4. A process as defined in Claim 3, wherein said temporary assembly heating step is performed by continuously heating a portion to be bonded of the temporary assembly under a vacuum of no more than 13.33 mPa ($10^{-4}$ Torr) at a temperature of no less than 900°C for no less than 10 minutes.

5. A process as defined in Claim 3, wherein said temporary assembly heating step is performed by continuously heating a portion to be bonded of the temporary assembly under a gas atmosphere at a temperature of no less than 900°C for no less than 10 minutes.

6. A process as defined in Claim 1, wherein said chromium oxide interposing step includes a step of forming by vacuum ion deposition a chromium oxide film of no less than 10 nm thickness on the surface to be bonded of the ceramics.

7. An article of ceramics and copper which comprises:
ceramics;
a copper article; and
chromium oxide bonding said ceramics and said copper article to each other.

8. An article as defined in Claim 7 wherein said article is a hermetic envelope or part thereof comprising insulating ceramics and the copper article hermetically bonded to each other.

9. A process for bonding a copper article to ceramics which comprises:
interposing a copper-chromium alloy consisting of copper and 0.1 to 0.6 wt. % chromium between the surfaces to be bonded of the ceramics and the copper article;
heating a temporary assembly of the ceramics, the copper article and the copper-chromium alloy under an atmosphere adapted to oxidize chromium but not to oxidize copper, at a temperature of less than the melting point of copper; and then slowly cooling the so-bonded assembly.

10. An article of ceramics and copper which comprises:
ceramics;
a copper article; and
a copper-chromium alloy comprising 0.1 to 0.6 wt. % chromium heated at a temperature of less than the melting point of copper, under an atmosphere to oxidize chromium but not to oxidize copper so as to bond said ceramics and said copper article to each other.

11. An article as defined in Claim 10, wherein the article is a hermetic envelope or part thereof comprising insulating ceramics and the copper article hermetically bonded to each other.

12. A process for bonding a copper-chromium alloy article to a ceramics material which comprises:
heating a temporary assembly of the ceramics and the copper-chromium alloy article comprising 0.1 to 0.6 wt. % chromium, with the surfaces to be bonded thereof in contact, under an atmosphere adapted to oxidize chromium but not to oxidize copper, at a temperature of less than the melting point of the copper-chromium alloy and then slowly cooling the so-bonded assembly.

13. An article of ceramics and copper-chromium alloy material which comprises:
ceramics; and
a copper-chromium alloy article comprising 0.1 to 0.6 wt. % chromium, both directly bonded to each other by heating a temporary assembly thereof at a temperature below the melting point of the copper-chromium alloy.

14. An article as defined in Claim 13, wherein the article is a hermetic envelope or part thereof comprising an insulating ceramics and the copper-chromium alloy article hermetically bonded to each other.

**Revendications**

1. Procédé de liaison d'un produit en cuivre avec des céramiques, caractérisé en ce qu'il comprend:
l'interposition d'oxyde de chrome entre les surfaces de céramique et du produit en cuivre qui sont à combiner;
chauffage d'un assemblage provisoire des céramiques, du produit en cuivre, et de l'oxyde de chrome sous une atmosphère qui n'oxyde pas le cuivre, à une température inférieure au point de fusion du cuivre; et puis
le refroidissement lent de l'assemblage ainsi combiné.

2. Procédé selon la revendication 1, caractérisé en ce que ladite étape d'interposition d'oxyde de chrome comprend les étapes de dépôt d'un film de chrome d'une épaisseur supérieure à 10 nm à la surface de céramique à combiner et d'oxydation du film de chrome.

3. Procédé selon la revendication 2, caractérisé en ce que ladite étape d'oxydation du film de chrome est réalisée par chauffage continu du film de chrome sous une atmosphère d'air de pression supérieure à 1,333 mPa ($10^{-5}$ Torr) à une température supérieure à 100°C pendant un temps supérieur à 10 min.

4. Procédé selon la revendication 3, caractérisé en ce que ladite étape de chauffage de l'assemblage provisoire est réalisée par chauffage continu d'une partie à combiner de l'assemblage provisoire sous un vide inférieur à 13,33 mPa ($10^{-4}$ Torr) à une température supérieure à 900°C pendant un temps supérieur à 10 min.

5. Procédé selon la revendication 3, caractérisé en ce que ladite étape de chauffage de l'assemblage provisoire est réalisée par chauffage continu d'une partie à combiner de l'assemblage provisoire sous une atmosphère gazeuse à une température supérieure à 900°C pendant un temps supérieur à 10 min.

6. Procédé selon la revendication 1, caractérisé en ce que ladite étape d'interposition d'oxyde de chrome comprend une étape de formation d'un film d'oxyde de chrome par dépôt ionique sous vide d'une épaisseur supérieure à 10 nm à la surface de la céramique à combiner.

7. Produit de céramique et de cuivre, caractérisé en ce qu'il comprend:

des céramiques;

un produit en cuivre; et

de l'oxyde de chrome liant lesdites céramiques et ledit product en cuivre ensemble.

8. Produit selon la revendication 7, caractérisé en ce que ledit produit est une ampoule hermétique ou une partie de cette dernière comprenant:

des céramiques isolantes et le produit en cuivre; liés hermétiquement ensemble.

9. Procédé de liaison d'un produit en cuivre avec des céramiques, caractérisé en ce qu'il comprend:

l'interposition d'un alliage de cuivre-chrome constituée de cuivre et de 0,1 à 0,6% en poids de chrome entre les surfaces à combiner de céramique et du produit en cuivre;

chauffage d'un assemblage provisoire de céramique, du produit en cuivre et d'alliage de cuivre-chrome sous une atmosphère adaptée pour oxyder le chrome sans oxyder le cuivre, à une température inférieure au point de fusion du cuivre; puis

le refroidissement lent de l'assemblage ainsi combiné.

10. Produit en céramique et en cuivre, caractérisé en ce qu'il comprend:

des céramiques;

un produit en cuivre; et

un alliage de cuivre-chrome comprenant de 0,1 à 0,6% en poids de chrome chauffé à une température inférieure au point de fusion du cuivre, sous une atmosphère qui oxyde le chrome sans oxyder le cuivre pour lier ensemble lesdites céramiques et ledit produit en cuivre.

11. Produit selon la revendication 10, caractérisé en ce que le produit est une partie d'ampoule hermétique comprenant des céramiques isolantes et le produit en cuivre liés ensemble de façon hermétique.

12. Procédé de liaison d'un produit en alliage de cuivrechrome avec un matériau de céramique, caractérisé en ce qu'il comprend:

le chauffage d'un assemblage provisoire de céramique et le produit en alliage de cuivre-chrome comprenant de 0,1 à 0,6% en poids de chrome, avec les surfaces de ces derniers à combiner en contact, sous une atmosphère adaptée pour oxyder le chrome sans oxyder le cuivre, à une température inférieure au point de fusion de l'alliage de cuivre-chrome; puis

le refroidissement lent de l'assemblage ainsi combiné.

13. Produit en céramique et en alliage de cuivre-chrome, caractérisé en ce que en ce qu'il comprend:

des céramiques; et

un produit en alliage de cuivre-chrome comprenant de 0,1 à 0,6% en poids de chrome, combinés directement ensemble par chauffage de l'assemblage provisoire de ces derniers à une température inférieure au point de fusion de l'alliage de cuivre-chrome.

14. Produit selon la revendication 13, caractérisé en ce que le produit est une ampoule hermétique ou une partie de cette dernière comprenant une céramique isolante et le produit en alliage de cuivre-chrome liés ensemble de façon hermétique.

## Patentansprüche

1. Verfahren zum Verbinden eines Gegenstandes aus Kupfer mit Keramikmaterialien, dadurch gekennzeichnet, daß zwischen den Oberflächen der Keramikmaterialien und des Kupfergegenstandes, welcher miteinander verbunden werden sollen, Chromoxid angeordnet wird; eine einstweilige Anordnung der Keramikmaterialien, des Kupfergegenstandes und des Chromoxids unter einer Atmosphäre, welche Kupfer nicht oxidiert, auf eine Temperatur von weniger als dem Schmelzpunkt des Kupfers erhitzt wird; und dann die so miteinander verbundene Anordnung langsam abgekühlt wird.

2. Verfahren nach Anspruch 1, dadurch gekennzeichnet, daß die Stufe der Zwischenanordnung des Chromoxids die Stufen des Aufschichtens eines Chromfilms von nicht weniger als 10 nm Stärke auf die zu verbindenden Keramikoberflächen und der Oxidation des Chromfilms einschließt.

3. Verfahren nach Anspruch 2, dadurch gekennzeichnet, daß die Stufe der Oxidation des Chromfilms dadurch durchgeführt wird, daß der Chromfilm fortlaufend unter einer Luftatmosphäre von nicht weniger als 1,333 mPa ($10^{-5}$ Torr) auf eine Temperatur von nicht weniger als 100°C für nicht weniger als 10 Minuten erhitzt wird.

4. Verfahren nach Anspruch 3, dadurch gekennzeichnet, daß die Erhitzungsstufe der einstweiligen Anordnung so durchgeführt wird, daß ein miteinander zu verbindender Teil der einstweiligen Anordnung unter einem Vakuum von nicht mehr als 13,33 mPa ($10^{-4}$ Torr) auf eine Temperatur von nicht weniger als 900°C für nicht weniger als 10 Minuten erhitzt wird.

5. Verfahren nach Anspruch 3, dadurch gekennzeichnet, daß die Erhitzungsstufe der einstweiligen Anordnung so durchgeführt wird, daß ein miteinander zu verbindender Teil der einstweiligen Anordnung unter einer Gasatmosphäre auf eine Temperatur von nicht weniger als 900°C für nicht weniger als 10 Minuten erhitzt wird.

6. Verfahren nach Anspruch 1, dadurch gekennzeichnet, daß die Stufe der Zwischenanordnung des Chromoxids eine Stufe der Ausbildung durch Vakuum-Ionenablagerung eines Chromoxidfilms von nicht weniger als 10 nm Stärke auf der miteinander zu verbindenden Oberfläche der Keramikmaterialien einschließt.

7. Gegenstand aus Keramikmaterialien und Kupfer, dadurch gekennzeichnet, daß er umfaßt:
Keramikmaterialien;
einen Gegenstand aus Kupfer; und
Chromoxid, welches diese Keramikmaterialien und diesen Gegenstand aus Kupfer miteinander verbindet.

8. Gegenstand nach Anspruch 7, dadurch gekennzeichnet, daß dieser Gegenstand ein hermetischer Mantel oder ein Teil hiervon ist, welcher isolierende Keramikmaterialien und den Gegenstand aus Kupfer, welche hermetisch miteinander verbunden sind, einschließt.

9. Verfahren zum Verbinden eines Gegenstandes aus Kupfer mit Keramikmaterialien, dadurch gekennzeichnet, daß es umfaßt:
Anordnung einer Kupfer-Chromlegierung, bestehend aus Kupfer und 0,1 bis 0,6 Gew.-% Chrom, zwischen den miteinander zu verbindenden Oberflächen der Keramikmaterialien und des Kupfergegenstandes; Erhitzen einer einstweiligen Anordnung der Keramikmaterialien, des Kupfergegenstandes und der Kupfer-Chromlegierung unter einer Atmosphäre, welche zur Oxidation des Chroms jedoch nicht zur Oxidation des Kupfers geeignet ist, bei einer Temperatur von weniger als dem Schmelzpunkt des Kupfers; und anschließendes langsames Abkühlen der so miteinander verbundenen Anordnung.

10. Gegenstand aus Keramikmaterialien und Kupfer, dadurch gekennzeichnet, daß er umfaßt:
Keramikmaterialien;
einen Kupfergegenstand; und
eine Kupfer-Chromlegierung, welche 0,1 bis 0,6 Gew.-% Chrom umfaßt und auf eine Temperatur von weniger als dem Schmelzpunkt des Kupfers unter einer Atmosphäre zur Oxidation des Chroms jedoch nicht zur Oxidation des Kupfers erhitzt worden ist, so daß die Keramikmaterialien und der Kupfergegenstand miteinander verbunden worden sind.

11. Gegenstand nach Anspruch 10, dadurch gekennzeichnet, daß der Gegenstand ein hermetischer Mantel oder ein Teil hiervon ist, welcher isolierende Keramikmaterialien und den Kupfergegenstand, hermetisch miteinander verbunden, umfaßt.

12. Verfahren zum Verbinden eines Gegenstandes aus Kupfer-Chromlegierung mit einem Keramikmaterial, dadurch gekennzeichnet, daß es umfaßt:
Erhitzen einer einsteweiligen Anordnung aud den Keramikmaterialien und dem Gegenstand aus Kupfer-Chromlegierung, welche 0,1 bis 0,6 Gew.-% Chrom enthält, wobei die miteinander zu verbindenden Oberflächen hiervon in Kontakt sind, unter einer Atmosphäre, welche zur Oxidation des Chroms jedoch nicht zur Oxidation des Kupfers geeignet ist, auf eine Temperatur von weniger als dem Schmelzpunkt der Kupfer-Chromlegierung; und anschließendes langsames Abkühlen der so miteinander verbundenen Anordnung.

13. Gegenstand aus Keramikmaterialien und einem Material aus Kupfer-Chromlegierung, dadurch gekennzeichnet, daß er umfaßt:
Keramikmaterialien; und
einen Gegenstand aus Kupfer-Chromlegierung, welche 0,1 bis 0,6 Gew.-% Chrom umfaßt, wobei beide direkt miteinander durch Erhitzen einer einstweiligen Anordnung hiervon auf eine Temperatur unterhalb des Schmelzpunktes der Kupfer-Chromlegierung miteinander verbunden sind.

14. Gegenstand nach Anspruch 13, dadurch gekennzeichnet, daß der Gegenstand ein hermetischer Mantel oder ein Teil hiervon ist, welcher ein isolierendes Keramikmaterial und den Gegenstand aus Kupfer-Chromlegierung, die hermetisch miteinander verbunden sind, umfaßt.

# FIG. 1

4 µm

# FIG. 2

4 µm

# FIG. 3

4 µm

# FIG. 4

4 µm

# FIG. 5

4 µm

# FIG. 6

# FIG. 7